# EUROPEAN PATENT APPLICATION

(11) **EP 4 654 803 A1**
(43) Date of publication of application: **26.11.2025**
(21) Application number: 25176154.0
(22) Date of filing: 13.05.2025
(51) Int. Cl.: H10K 59/80, H10K 59/122, H10K 59/40

(54) **LIGHT EMITTING DISPLAY DEVICE, MANUFACTURING METHOD THEREOF, AND VEHICLE HAVING LIGHT EMITTING DISPLAY DEVICE**

(30) Priority: 23.05.2024 KR 20240067221
(71) Applicant: Samsung Display Co., Ltd., Yongin-si, Gyeonggi-do 17113 (KR)
(72) Inventor: Sung, Woo Yong, Yongin-si, Gyeonggi-do (KR)
(74) Representative: Gulde & Partner

(57) **Abstract**

According to embodiments, a light emitting display device includes a substrate, a light emitting layer disposed on the substrate, and an encapsulation layer that covers the light emitting layer and includes a lower inorganic encapsulation layer and an organic encapsulation layer. The organic encapsulation layer includes a plurality of light blocking structures extending longitudinally in one direction in an area overlapping the light emitting layer. Each of the plurality of light blocking structures includes a barrier layer, a capping layer, and a space filled by an air and surrounded by the barrier layer and the capping layer.

## Description

### 1. FIELD

The present disclosure relates to a light emitting display device, a manufacturing method thereof, and a vehicle including the light emitting display device.

### 2. DESCRIPTION OF THE RELATED ART

A display device is a device that displays a screen and includes a liquid crystal display (LCD) and an organic light emitting diode (OLED). These display devices are used in various electronic devices such as mobile phones, navigation devices, digital cameras, electronic books, portable game consoles, and various terminals.

In addition, display devices can be used in a variety of fields other than electronic devices, and in the case of vehicles, a direction of digitally displaying conventional analog instrument panels and center fascias using display devices is being developed.

### SUMMARY

Embodiments are intended to block light emitted from a display device from being emitted in a specific direction.

This is to ensure that the light emitted from the display device used in the vehicle is provided to the driver's eyes and does not interfere with driving.

This is also to prevent the display device used in a vehicle from reflecting from the front glass of the vehicle at night and blocking the driver's view.

The encapsulation layer of the display device according to an embodiment is intended to block moisture and air from being injected into the light emitting layer while additionally improving the sensing performance of the touch sensing layer located on the encapsulation layer.

According to embodiments, a light emitting display device includes a substrate; a light emitting layer disposed on the substrate; and an encapsulation layer covering the light emitting layer and including a lower inorganic encapsulation layer, an organic encapsulation layer, and an upper inorganic encapsulation layer. The organic encapsulation layer includes a plurality of light blocking structures extending longitudinally in one direction in an area overlapping the light emitting layer. Each of the plurality of light blocking structures includes a barrier layer, a capping layer, and a space filled by an air and surrounded by the barrier layer and the capping layer.

The barrier layer may include one of TiO₂, Al₂O₃, SiO₂, and Fe₂O₃ and has low-reflection characteristics.

Each of the plurality of light blocking structures may further include a hydrophobic coating layer disposed inside the barrier layer.

The hydrophobic coating layer and the capping layer may be in contact with each other.

The capping layer may include a material having a black color, a specific color, or being transparent.

The plurality of light blocking structures may be disposed only in areas overlapping the light emitting layer.

Each of the plurality of light blocking structures may have a height of 4 µm or more and 12 µm or less, a width of 1 µm or more and 2 µm or less, and a gap between adjacent light blocking structures of the plurality of light blocking structures may be 1 µm or more.

The gap between the adjacent light blocking structures may be at least four times greater than the width of each of the plurality of light blocking structures.

The light emitting display device may further include an anode disposed between the substrate and the light emitting layer; an inorganic pixel defining layer having an opening corresponding to the light emitting layer; a separator disposed on the inorganic pixel defining layer and including a lower separator including a metal and an upper separator; and a cathode disposed on the light emitting layer, wherein the upper separator may include a structure that protrudes more than the lower separator.

The light emitting display device may further include a separation cathode disposed above the upper separator; a plurality of cathodes including the cathode; and a plurality of light emitting layers comprising the light emitting layer. Adjacent cathodes of the plurality of cathodes disposed on adjacent light emitting layers of the plurality of light emitting layers may be electrically connected by the lower separator or the upper separator.

The light emitting display device may further include an anode protective layer disposed between the inorganic pixel defining layer and the anode.

A method of manufacturing a light emitting display device according to an embodiment includes the steps of laminating a lower inorganic encapsulation layer covering a light emitting layer disposed on a substrate; forming an organic encapsulation layer disposed on the lower inorganic encapsulation layer and including a plurality of light blocking structures extending in one direction; and laminating an upper inorganic encapsulation layer covering the plurality of light blocking structures and the organic encapsulation layer. The forming of the organic encapsulation layer including the plurality of light blocking structures includes: stacking and etching organic materials to form the organic encapsulation layer having a plurality of trenches; laminating a barrier layer material on an upper surface of the organic encapsulation layer and an inner surface of the plurality of trenches; forming a capping part material on the barrier layer material disposed on the upper surface of the organic encapsulation layer and at an entrance of the plurality of trenches; and exposing the upper surface of the organic encapsulation layer by removing the capping part material and the barrier layer material.

The method of manufacturing a light emitting display device may further include forming a hydrophobic coating layer on a part of the barrier layer material disposed in the plurality of trenches between the step of laminating the barrier layer material and the step of forming the capping part material.

The barrier layer may include one of TiO₂, Al₂O₃, SiO₂, and Fe₂O₃, and has low-reflection characteristics.

The method of manufacturing a light emitting display device may further include before laminating the lower inorganic encapsulation layer, forming an anode and an anode protective layer by sequentially stacking an anode material and an anode protective layer material on the substrate; forming an inorganic pixel defining layer having an opening exposing the anode protective layer; forming a separator including a lower separator and an upper separator on the inorganic pixel defining layer; exposing the anode by etching the exposed anode protective layer; and forming the light emitting layer on the exposed anode. The upper separator may have a structure in which the upper separator protrudes more than the lower separator.

A vehicle according to an embodiment includes a first light emitting display device. The first light emitting display device comprises: a first substrate; a first light emitting layer disposed on the first substrate; and a first encapsulation layer covering the first light emitting layer and including a first lower inorganic encapsulation layer, a first organic encapsulation layer, and a first upper inorganic encapsulation layer. The first organic encapsulation layer includes a plurality of first light blocking structures in an area overlapping the first light emitting layer, and each of the plurality of first light blocking structures includes a first barrier layer, a first capping layer, and a first space filled by an air and surrounded by the first barrier layer and the first capping layer.

The vehicle may further include a second light emitting display device. The second light emitting display device comprises: a second substrate; a second light emitting layer disposed on the second substrate; and a second encapsulation layer covering the second light emitting layer and including a second lower inorganic encapsulation layer, a second organic encapsulation layer, and a second upper inorganic encapsulation layer. The second organic encapsulation layer may include a plurality of second light blocking structures in an area overlapping the second light emitting layer. Each of the plurality of second light blocking structures may include a second barrier layer, a second capping layer, and a second space filled by the air and surrounded by the second barrier layer and the second capping layer.

The plurality of first light blocking structures may extend in a first direction, and the plurality of second light blocking structures may extend in a direction intersecting the first direction.

Each of the plurality of first light blocking structures may further include a first hydrophobic coating layer disposed inside the first barrier layer or each of the plurality of second light blocking structures may further includes a second hydrophobic coating layer disposed inside the second barrier layer.

Each of the plurality of first light blocking structures or the plurality of second light blocking structures may have a height of 4 µm or more and 12 µm or less, a width of 1 µm or more and 2 µm or less, and a gap between adjacent first light blocking structures of the plurality of first light blocking structures, and a gap between adjacent second light blocking structures of the plurality of second light blocking structures is 1 µm or more. The gap between the adjacent first light blocking structures or between the adjacent second light blocking structures may be at least 4 times the width of each of the plurality of first light blocking structures or the plurality of second light blocking structures.

According to embodiments, a plurality of light blocking structures are formed on the entire surface of the light emitting layer in one direction, so that light provided from the light emitting layer is not emitted in a specific direction.

By preventing the light emitted from the display device used in the vehicle from being provided to the vehicle's front glass, light is not reflected from the vehicle's front glass at night and does not interfere with the driver's vision.

The light emitted from the display device located on the passenger seat is not provided to the driver, so it does not interfere with driving.

Compared to a comparative example that forms a light blocking structure in the form of a film in front of the light emitting layer, this embodiment is formed within the encapsulation layer of the direct light emitting display device, so there is no problem with misalignment, it is also thin, and it has the advantage of being able to block the ingress of moisture and air into the light emitting layer while controlling the direction in which the image is displayed.

This embodiment forms a light blocking structure with a space containing air in the organic encapsulation layer among the encapsulation layers of the direct light emitting display device, which lowers the entire dielectric constant value of the organic encapsulation layer, and can also enhance the encapsulation performance of the touch sensing layer located above the encapsulation layer and reduce noise.

### BRIEF DESCRIPTION OF THE DRAWINGS

FIG. 1 is a schematic cross-sectional view of a light emitting display device according to an embodiment.
FIG. 2 is a cross-sectional view schematically showing the direction in which light travels in the light emitting layer of a light emitting display device according to an embodiment.
FIG. 3 is a graph showing the dielectric constant of an encapsulation layer according to an embodiment.
FIG. 4 is a cross-sectional view of a light emitting display device according to an embodiment.
FIG. 5 is an enlarged cross-sectional view of a part of a light emitting display device according to an embodiment.
FIGS. 6, 7, 8, 9, 10, 11, 12, 13, 14, 15, 16, 17, 18, and 19 are diagrams sequentially showing a method of manufacturing a light emitting display device according to an embodiment.
FIG. 20 and FIG. 21 are cross-sectional views schematically showing a light emitting display device according to an embodiment.
FIGS. 22A, 22B are a diagram illustrating a case where a light emitting display device according to a comparative example is applied to a vehicle.
FIGS. 23A, 23B are a diagram illustrating a case where a light emitting display device according to an embodiment is applied to a vehicle.
FIG. 24 is a diagram illustrating a case where a light emitting display device according to another embodiment is applied to a vehicle.
FIG. 25 is a diagram illustrating a cross-sectional structure of a light emitting display device according to an embodiment.

### DETAILED DESCRIPTION

Hereinafter, with reference to the attached drawings, various embodiments of the present disclosure will be described in detail so that those skilled in the art could easily implement the inventive concept. The inventive concept may be implemented in many different forms and is not limited to the embodiments described herein.

In order to clearly explain the present disclosure, parts that are not relevant to the description are omitted, and identical or similar components are assigned the same reference numerals throughout the specification.

In addition, the size and thickness of each component shown in the drawings are arbitrarily shown for convenience of explanation, so the present disclosure is not necessarily limited to that which is shown. In the drawings, the thickness is enlarged to clearly express various layers and regions. In the drawings, for convenience of explanation, the thicknesses of some layers and regions are exaggerated.

Additionally, when a part, such as a layer, membrane, region, plate, or component is said to be "above" or "on" another part, this means not only when it is "directly above" another part, but also when there is another part in between. In contrast, when an element is referred to as being "directly on" another element, there are no intervening elements present. In addition, being "above" or "on" a reference part means being located above or below the reference part, and does not necessarily mean being located "above" or "on" it in the direction opposite to gravity.

In addition, throughout the specification, when a part is said to "include" a certain component, this means that it may further include other components rather than excluding other components, unless specifically stated to the contrary.

In addition, throughout the specification, when reference is made to "on a plane," this means when the target part is viewed from above, and when reference is made to "in a cross-section," this means when a cross-section of the target part is cut vertically and viewed from the side.

In addition, throughout the specification, when "connected" is used, this does not mean only when two or more components are directly connected, but when two or more components are indirectly connected through other components, they are physically connected, and this may include not only the case of being connected or electrically connected, but also the case where parts that are referred to by different names depending on location or function, are substantially connected to each other.

In addition, throughout the specification, when a part such as a wiring, layer, film, region, plate, or component is said to "extend in the first or second direction," this does not mean not only a straight shape extending in that direction, but also structures that extend overall along the first or second direction, and also includes structures that are bent at some part, have a zigzag structure, or extend while including a curved structure.

In addition, electronic devices (e.g., mobile phones, TVs, monitors, laptop computers, etc.) containing display devices, display panels, etc. described in the specification, or display devices, display panels, etc. manufactured by the manufacturing method described in the specification, included herein are also not excluded from the scope of this specification.

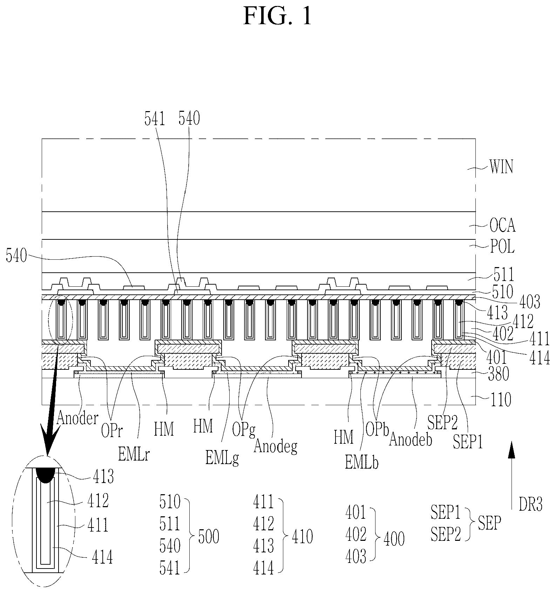

Hereinafter, a light emitting display device according to an embodiment will be examined through FIG. 1.

FIG. 1 is a schematic cross-sectional view of a light emitting display device according to an embodiment.

In FIG. 1, three light emitting diodes representing different colors R, G, B located adjacent to each other are briefly shown, and each light emitting diode includes light emitting layers EMLr, EMLg, EMLb.

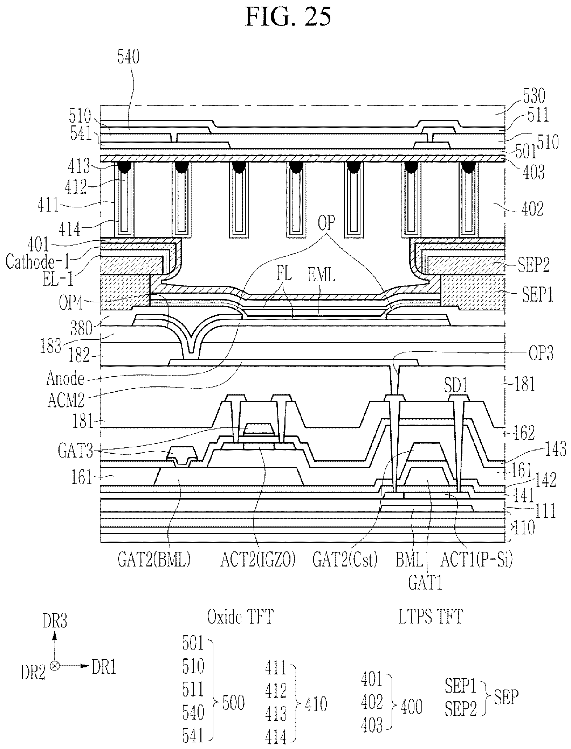

Each light emitting layer EMLr, EMLg, EMLb is a part of the light emitting diode that emits light, and is partitioned by an inorganic pixel defining layer 380 and a separator SEP located thereon. Each light emitting layer EMLr, EMLg, EMLb may have a structure that overlaps the openings OPr, OPg, OPb located in the inorganic pixel defining layer 380 and the separator SEP and is exposed to the top. Depending on the embodiment, each light emitting layer EMLr, EMLg, EMLb may be located only within each opening OPr, OPg, OPb of the inorganic pixel defining layer 380 and the separator SEP. Although not shown in FIG. 1, a cathode and an encapsulation layer may be located on the inorganic pixel defining layer 380 and the light emitting layers EMLr, EMLg, EMLb, and an anode Anoder, Anodeg, Anodeb may be located below each of the light emitting layers EMLr, EMLg, EMLb. Here, one anode Andoer, Anodeg, Anodeb, one light emitting layer EMLr, EMLg, EMLb, and a cathode may constitute one light emitting diode. The detailed stacked structure of the light emitting diode according to an embodiment will be examined through FIG. 25.

In FIG. 1, the structure positioned between the anode Anoder, Anodeg, Anodeb, and the inorganic pixel defining layer 380 and a substrate 110 is omitted. However, between the substrate 110 and the anode Anoder, Anodeg, Anodeb, and the inorganic pixel defining layer 380 is located a pixel circuitry including a transistor that supplies current to the anode Anoder, Anodeg, Anodeb, which is collectively referred to as a pixel.

The inorganic pixel defining layer 380 (hereinafter also referred to as the pixel defining layer) is formed of an inorganic pixel defining layer including an inorganic material, wherein the inorganic insulating material may include silicon oxide SiOx, silicon nitride SiNx, and silicon oxynitride SiONx. The inorganic pixel defining layer 380 may be formed to have a lower height than the organic pixel defining layer formed of an organic material. As a result, the separator SEP that separates adjacent light emitting layers EMLr, EMLg, EMLb may be further formed on the inorganic pixel defining layer 380. Using an inorganic pixel defining layer 380 has the advantage of not generating gas during processing compared to a pixel defining layer formed of an organic material.

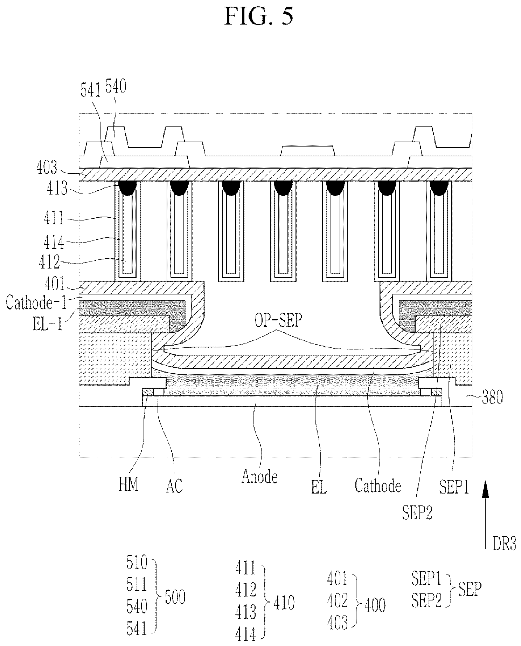

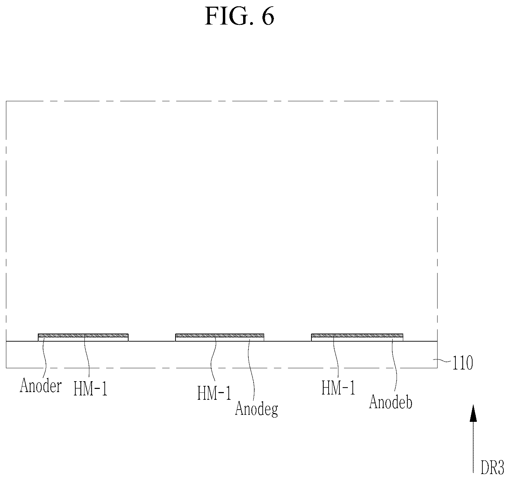

In the embodiment of FIG. 1, an anode protective layer HM is located between the inorganic pixel defining layer 380 and a top surface of the anode, so that the inorganic pixel defining layer 380 and the top surface of the anode do not come into direct contact with each other (refer to FIG. 5). The anode protective layer HM serves to protect the anode during the process of forming the inorganic pixel defining layer 380 and the separator SEP, and is subsequently removed (refer to FIGS. 6 to 9), although some remaining parts may be located beneath the inorganic pixel defining layer 380.

In FIG. 1, the separator SEP is formed of a double layer of separators SEP1, SEP2. The lower separator SEP1, hereinafter also referred to as the first separator, and the upper separator SEP2, hereinafter also referred to as the second separator, may each have conductivity and include a metal. Here, the lower separator SEP1 and the upper separator SEP2 may include metals or metal alloys such as aluminum (Al), copper (Cu), molybdenum (Mo), titanium (Ti), etc., and can be formed from different metals. The lower separator SEP1 according to an embodiment may include aluminum (Al), and the upper separator SEP2 according to an embodiment may include titanium (Ti). The width of the upper separator SEP2 is wider than that of the lower separator SEP1, and both ends of the upper separator SEP2 are formed in a structure that protrudes from the top of the lower separator SEP1. Due to the protruding structure of the upper separator SEP2, the layers laminated on the upper separator SEP2 have a structure that is cut off at the protruding part of the upper separator SEP2 (see FIG. 5), so that they can be separated from each other without a separate etching process. In particular, if a cathode is formed on the separator SEP, the cathode may be electrically disconnected, but since the separator SEP is conductive, adjacent cathodes can be electrically connected to each other (see FIG. 5).

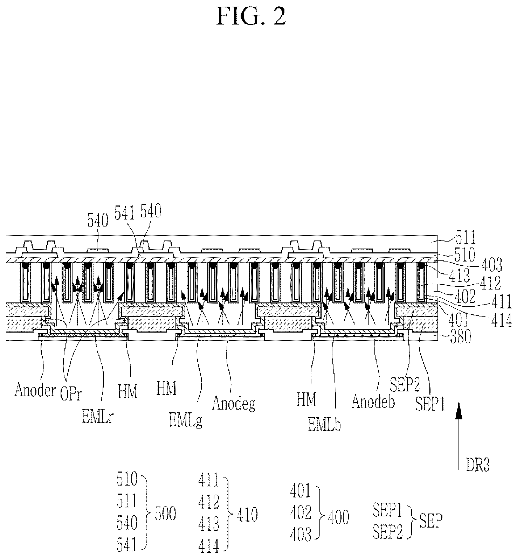

In FIG. 1, an encapsulation layer 400 is located on top of the light emitting diode and the separator SEP. The encapsulation layer 400 has a structure including a lower inorganic encapsulation layer 401, an organic encapsulation layer 402, and an upper inorganic encapsulation layer 403. The organic encapsulation layer 402 has a structure that is elongated in one direction, and a plurality of light blocking structures 410 are formed to limit the direction of light emitted from the light emitting layers EMLr, EMLg, EMLb (see FIG. 2). In the embodiment of FIG. 1, the light blocking structure 410 includes a barrier layer 411, a space 412 filled by an air, and a capping part 413 within the organic encapsulation layer 402, and in some embodiments, a hydrophobic coating layer 414 is further formed on the inside of the barrier layer 411. Referring to FIG. 1, the light blocking structure 410 includes the barrier layer 411, the capping part 413, and the space 412 surrounded by the barrier layer 411 and the capping part 413, and the light blocking structure 410 may further include the hydrophobic coating layer 414 located on the inside of the barrier layer 411.

In FIG. 1, the lower inorganic encapsulation layer 401 is located on top of a cathode (not shown) and the separator SEP included in the light emitting diode. Specifically, the lower inorganic encapsulation layer 401 is located not only on the top of the light emitting diode and on the top of the upper separator SEP2, but also on the side of the upper separator SEP2 and the side of the lower separator SEP1. The lower inorganic encapsulation layer 401 may be formed to be continuously connected to the side surface of the upper separator SEP2 and the side surface of the lower separator SEP1. Here, the lower inorganic encapsulation layer 401 may include an inorganic insulating material, and the inorganic insulating material may include one of silicon oxide SiOx, silicon nitride SiNx, and silicon oxynitride SiONx.

The organic encapsulation layer 402 including the light blocking structure 410 is located on the lower inorganic encapsulation layer 401.

The organic encapsulation layer 402 includes an organic material, and the organic material may include an acrylic-based organic material or a silicone-based organic material. The acrylic-based organic material according to an embodiment may be polyacrylate, and the silicone-based organic material according to an embodiment may be curable polydimethylsiloxane, acrylic polydimethylsiloxane, or epoxy polydimethylsiloxane.

The light blocking structure 410 is formed in the organic encapsulation layer 402 and may be located in a non-penetrated groove or a penetrating hole.

The light blocking structure 410 includes the barrier layer 411, the space 412, and the capping part 413, and the embodiment of FIG. 1 additionally includes the hydrophobic coating layer 414 on the inside of the barrier layer 411. Here, the light blocking structure 410 may be formed to have a height of 4 µm to 12 µm, a width of 1 µm to 2 µm, and a pitch of 0.1 µm to 20 µm. The gap between adjacent light blocking structures 410 can be formed to be 1 µm or more, and the value of the gap can be adjusted according to the viewing angle to be blocked through the light blocking structure 410. Here, the viewing angle may mean an angle at which light emitted from the light emitting layer EMLg is blocked from being emitted beyond a certain angle based on the normal direction (refer to DR3 direction). Depending on the embodiment, the ratio of the distance between adjacent light blocking structures 410 and the height of the light blocking structures 410 may be 1:3. However, this ratio may change depending on the viewing angle.

In an embodiment, the ratio of the width of the light blocking structures 410 and the gap between adjacent light blocking structures 410 may be 1:4, and the light emitted from the light emitting layer can be transmitted to the front surface, and the gap between the light blocking structures 410 can be widened to have a gap of more than four times the width of the light blocking structures 410. The numerical range for the light blocking structures 410 as described above corresponds to the numerical range of the groove or hole of the organic encapsulation layer 402, and may have a different numerical range depending on the embodiment.

Specifically, the barrier layer 411 is located on the inner wall of the groove or hole of the organic encapsulation layer 402, and in the case of a penetrated hole, the barrier layer 411 may also be located on the upper surface of the lower inorganic encapsulation layer 401 beneath the organic encapsulation layer 402. The barrier layer 411 may be formed of a material containing metal oxide, examples of which may be TiO₂, Al₂O₃, SiO₂, and Fe₂O₃. The barrier layer 411 may be formed of a metal oxide material through chemical vapor deposition CVD or atomic layer deposition ALD. Using the atomic layer deposition method, the deposited barrier layer 411 has good step coverage, so even if there are steps, the barrier layer 411 can be formed continuously without interruption, sufficiently performing its role as a barrier that separates the organic encapsulation layer 402 and the space 412. The barrier layer 411 contains metal oxide, and thus it has total reflection characteristics and may hereinafter be referred to as a low-reflection layer. The low-reflection characteristics of the barrier layer 411 may prevent light emitted from the light emitting layers EMLr, EMLg, EMLb included in the light emitting diode from being reflected and emitted to the front surface.

In the embodiment of FIG. 1, a hydrophobic coating layer 414 is further formed within the barrier layer 411. The hydrophobic coating layer 414 is a layer with hydrophobic properties, and allows moisture or moisture contained in the air to pass through the barrier layer 411, the organic encapsulation layer 402, and/or the lower inorganic encapsulation layer 401, etc. to the light emitting layer EMLr, EMLg, EMLb, and may not be included, depending on the embodiment.

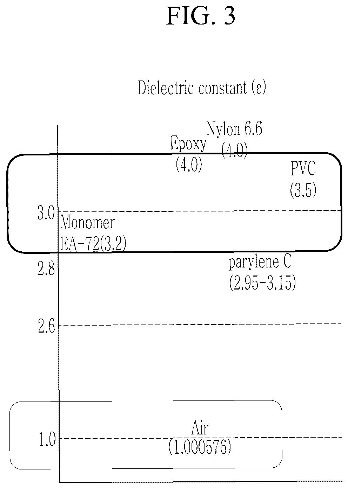

In the embodiment of FIG. 1, the space 412 filled by an air is formed within the barrier layer 411 and the hydrophobic coating layer 414. The air located in the space 412 has a lower dielectric constant (see FIG. 3) than other organic or inorganic materials, allowing the light blocking structure 410 and the entire organic encapsulation layer 402 to have low dielectric characteristics. Additionally, since air has a low refractive index, when light emitted from the light emitting layers EMLr, EMLg, EMLb enters the space 412 at an angle greater than the critical angle, it is totally reflected and does not enter the light blocking structure 410 that includes the space 412. In addition, even if total reflection does not occur, the light entering the space 412 is refracted at a large angle, and as a result, it proceeds in a direction approximately towards the front direction (DR3 direction in FIG. 1), so the light blocking structure 410 can perform the role of blocking light in a certain direction. The angle at which the light blocking structure 410 blocks light may be optimized by adjusting the refractive index of the adjacent layer.

In the embodiment of FIG. 1, the barrier layer 411 and the hydrophobic coating layer 414 are located on the side and bottom surfaces of the space 412, but the capping part 413 is located on the upper surface. One end of the capping part 413 may have a structure in contact with one end of the hydrophobic coating layer 414.

The capping part 413 according to the embodiment of FIG. 1 is made of a material that can block light and may be black. The capping part 413 may be formed of the same material as the light blocking layer (black matrix) used in the light emitting display device, and may be formed of an organic material containing black pigment. Here, an example of a material that can block light includes substances that cause chemical changes when exposed to light (photoresist), and as black pigments, and it may include carbon black, carbon nanotubes, resins or pastes containing black dyes, metal particles such as nickel, aluminum, molybdenum, and their alloys, and metal oxide particles (for example, chromium nitride).

The capping part 413 may have a structure whose thickness becomes thicker toward the center, and its thickest structure may be at the center of the space 412.

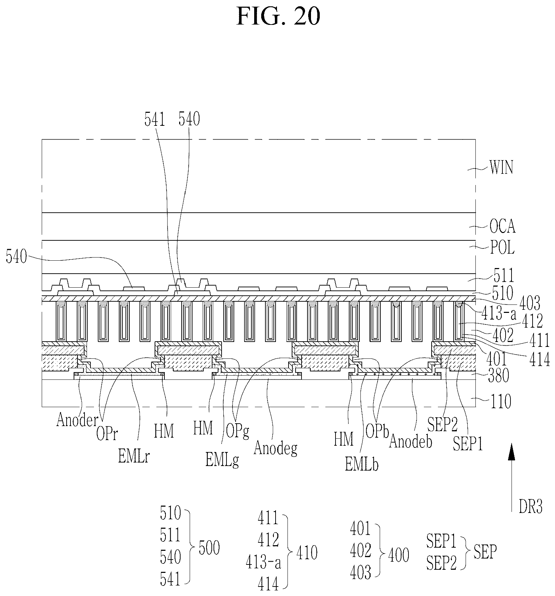

Since light incident on the capping part 413 is blocked, the space 412 in the light blocking structure 410 may play an assisting role in preventing light from being emitted beyond a certain angle. The capping part 413 may be formed of a material other than black or a transparent material depending on the embodiment (see FIG. 20).

The light blocking structure 410 may have a structure that extends longitudinally in one direction in the light emitting display device, and the capping part 413 may also extend longitudinally in the same direction. Each light emitting layer EMLr, EMLg, EMLb has a structure that overlaps at least one light blocking structure 410, and in FIG. 1, three light blocking structures 410 have a structure that overlaps one light emitting layer EMLr, EMLg, EMLb. Depending on the embodiment, the number and location of the light blocking structures 410 overlapping the light emitting layers EMLr, EMLg, EMLb may vary.

Referring to FIG. 1, the light blocking structure 410 is shown as a pillar with a constant width, but according to the embodiment, the width may vary depending on the height, and the width of the middle part may be thicker, or the width of the upper or lower part may be thicker.

The upper inorganic encapsulation layer 403 is located on the light blocking structure 410 and the organic encapsulation layer 402. The upper inorganic encapsulation layer 403 may include an inorganic insulating material, similar to the lower inorganic encapsulation layer 401, and the inorganic insulating material may include one of silicon oxide SiOx, silicon nitride SiNx, and silicon oxynitride SiONx.

In the embodiment of FIG. 1, the encapsulation layer 400 includes the lower inorganic encapsulation layer 401, the organic encapsulation layer 402, and the upper inorganic encapsulation layer 403, serving to prevent moisture or air from entering the light emitting layers EMLr, EMLg, EMLb. However, in order to prevent the problem of deterioration of encapsulation properties due to the light blocking structure 410 formed on the organic encapsulation layer 402, the hydrophobic coating layer 414 may be additionally formed within the light blocking structure 410.

In addition, in the embodiment of FIG. 1, to prevent moisture or air from entering the additional light emitting layers EMLr, EMLg, EMLb, a triple-layer structure is formed consisting of the lower inorganic encapsulation layer 401, the separator SEP, and the inorganic pixel defining layer 380.That is, by forming a double-layered separator SEP made of metal between the inorganic pixel defining layer 380 and the lower inorganic encapsulation layer 401 formed of inorganic material, a layered structure containing metal can be formed between the inorganic layers formed by chemical vapor deposition, which can additionally block the ingress of moisture or air from the outside. Accordingly, hereinafter, the lower inorganic encapsulation layer 401, the separator SEP, and the inorganic pixel defining layer 380 may also be referred to as additional encapsulation layers. Since the additional encapsulation layer and the encapsulation layer 400 include the lower inorganic encapsulation layer 401, there are a total of five layers-namely, the upper inorganic encapsulation layer 403, the organic encapsulation layer 402, and the lower inorganic encapsulation layer 401, the separator SEP and the inorganic pixel defining layer 380, which may also be referred to as overall encapsulation layers.

A touch sensing layer 500 for touch sensing is located on the upper inorganic encapsulation layer 403, and the touch sensing layer 500 includes sensing insulating layers 510 and 511 and a plurality of sensing electrodes 540 and 541. In the embodiment of FIG. 1, touch can be sensed in a capacitive manner using two sensing electrodes 540 and 541.

Specifically, a plurality of sensing electrodes 540 and 541 are formed on the upper inorganic encapsulation layer 403 of the encapsulation layer 400. The plurality of sensing electrodes 540 and 541 are formed of a first sensing electrode and a second sensing electrode, and in FIG. 1, the first sensing electrode is shown as a single-layer first sensing electrode 540, and the second sensing electrode is shown as a double-layer second sensing electrode 540, 541 in which two conductive layers are connected.

The second sensing insulating layer 510 is located between the two conductive layers for insulation, and the sensing electrodes 540 and 541 are covered with the third sensing insulating layer 511. Here, the sensing electrodes 540, 541 may include metals or metal alloys such as aluminum (Al), copper (Cu), silver (Ag), gold (Au), molybdenum (Mo), titanium (Ti), and tantalum (Ta), and can be composed of either a single layer or multiple layers. The sensing insulating layers 510 and 511 may be formed of organic or inorganic materials.

A polarizer POL, an adhesive layer OCA, and a cover window WIN may be sequentially located on the touch sensing layer 500. The polarizer POL may be located to reduce the degree to which external light is reflected from the light emitting display device, and the cover window WIN may be formed to protect the light emitting display device. The adhesive layer OCA has transparent properties and serves to attach the polarizer POL and cover window WIN. The polarizer POL may also be attached to the light emitting display device through an adhesive layer.

In the above, the structure of the light emitting display device according to FIG. 1 was looked at as a whole. Referring to FIGS. 2 and 3 to characterize the light emitting display device according to the embodiment of FIG. 1, the structure of FIG. 2 will be examined.

FIG. 2 is a cross-sectional view schematically showing the direction in which light travels in the light emitting layer of a light emitting display device according to an embodiment.

FIG. 2 illustrates a part of FIG. 1 and additionally illustrates some of the paths through which light emitted from the light emitting layers EMLr, EMLg, EMLb are provided to the front surface.

Referring to FIG. 2, the light emitted from the light emitting layers EMLr, EMLg, EMLb is not transmitted to the front surface through the light blocking structure 410, but is transmitted to the front surface through the part where the light blocking structure 410 is not located. As a result, the light emitted from the light emitting layers EMLr, EMLg, EMLb may not propagate at angles greater than a certain angle (viewing angle), and consequently, the image displayed by the light emitting display device may not be recognizable at angles greater than a certain angle (viewing angle).

In addition, the embodiment of FIG. 1 has another effect by forming a light blocking structure 410 within the organic encapsulation layer 402 among the encapsulation layers 400, and one of the effects is examined through FIG. 3.

FIG. 3 is a graph showing the dielectric constant of an encapsulation layer according to an embodiment.

Referring to FIG. 3, the monomer formed in the organic encapsulation layer 402 generally has a dielectric constant value of 2.95 or more and 3.15 or less, and has an average dielectric constant value of 3.

However, the light blocking structure 410 is located in the organic encapsulation layer 402 according to the embodiment of FIG. 1, and most of the light blocking structures 410 occupy the space 412, and the air located in the space 412 has a dielectric constant value close to 1. Therefore, the organic encapsulation layer 402 according to the embodiment of FIG. 1 has an overall dielectric constant value lower than that of the monomer, and is formed as an organic encapsulation layer 402 with a low dielectric constant. In this way, when the overall dielectric constant value of the organic encapsulation layer is lowered, the parasitic capacitance located around the touch sensing layer 500 located on the encapsulation layer 400 is reduced and noise is also reduced, and as a result, the sensing performance of the touch sensing layer 500 can be improved.

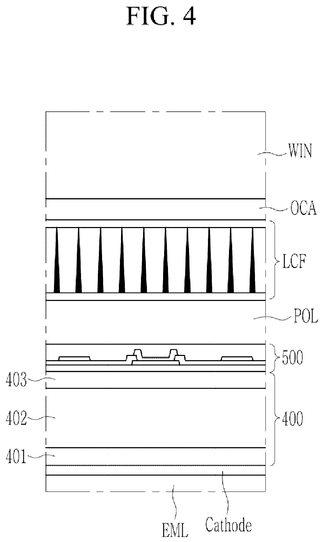

Below, the advantages of the embodiment of FIG. 1 through a comparative example of FIG. 4 will be examined.

FIG. 4 is a cross-sectional view of a light emitting display device according to the comparative example.

The comparative example of FIG. 4, unlike the embodiment of FIG. 1, forms a light control film LCF between the polarizer POL and the adhesive layer OCA to prevent light from traveling in a certain direction, and does not include a separate pattern within the encapsulation layer 400, especially the organic encapsulation layer 402. Here, the light control film LCF contains a black linear pattern to block light.

Referring to FIG. 4 of the comparative example, the light control film LCF is formed as thick as the example of FIG. 1, and the light control film LCF generally has a thickness of 30 µm or more. Therefore, the embodiment of FIG. 1 has the advantage of reducing the thickness by at least 30 µm while controlling the same viewing angle as that of FIG. 4. Considering that the thickness of the encapsulation layer 400 is generally 10 µm, it can be seen that the embodiment of FIG. 1 is significantly reduced in thickness.

In addition, while the comparative example where the light control film LCF is attached may have a problem of misalignment, and moiré phenomenon may occur if it is attached incorrectly, in the embodiment of FIG. 1, there is no misalignment problem, and can easily eliminate moiré by adjusting the gap of the light blocking structure 410.

In addition, the comparative example of attaching a light control film LCF has the disadvantages of increased manufacturing costs and reduced transmittance due to light loss occurring at the interface caused by the adhesive, etc. during attachment, but in the embodiment of FIG. 1, these disadvantages do not exist.

In FIG. 1, the cathode included in the light emitting diode is schematically shown, but hereinafter, the structure of the light emitting diode and the cathode will be examined in detail through the embodiment of FIG. 5.

FIG. 5 is an enlarged cross-sectional view of a part of a light emitting display device according to an embodiment.

Not shown in FIG. 1, but referring to FIG. 5, a middle layer EL including a light emitting layer and a cathode Cathode may be further included on an anode Anode and the separator SEP. The light emitting diode further includes the anode Anode, the middle layer EL including a light emitting layer, and the cathode Cathode.

Referring to FIG. 5, the middle layer EL included in the light emitting diode is located within an opening OP-SEP of the separator SEP, and a separation middle layer EL-1 not included in the light emitting diode is located on the separator SEP. Here, the middle layer EL included in the light emitting diode may cover the anode Anode and the inorganic pixel defining layer 380, and may not abut the remaining anode protective layer HM located between the inorganic pixel defining layer 380 and the anode Anode, where the empty space is located. The cathode Cathode that is included in the light emitting diode is located on top of the middle layer EL, and an isolation cathode Cathode-1 that is not included in the light emitting diode is located on top of the separator SEP and the separation middle layer EL-1.

According to the protruding structure of the upper separator SEP2, the cathode may be disconnected as the cathode Cathode and the isolation cathode Cathode-1 , as shown in FIG. 5. However, since the lower separator SEP1 and the upper separator SEP2 are conductive, adjacent cathodes, e.g., the cathode Cathode and the isolation cathode Cathode-1, are electrically connected through the separator SEP. According to an embodiment, unlike in FIG. 5, the cathode is formed using a damage-free sputter device with a relatively low angle of incidence, so that the cathode is located while being connected from the sides of both the upper separator SEP2 and the lower separator SEP1, and may have a structure that extends over the separator SEP.

Hereinafter, a manufacturing method of forming a light emitting display device according to an embodiment will be described in detail through FIGS. 6 to 19.

FIG. 6 to FIG. 19 are diagrams sequentially showing a method of manufacturing a light emitting display device according to an embodiment.

FIG. 6 to FIG. 19 sequentially illustrate a method of manufacturing a part of the light emitting display device according to the embodiment of FIG. 1.

First, referring to FIG. 6, materials for the anode and for an anode protective layer HM-1 are sequentially deposited on the substrate 110, and then etched together to form the anode, e.g., the anode Anoder, Anodeg, Anodeb, and the anode protective layer HM-1. The anode protective layer HM-1 may have the same size and planar shape as the anode, and may serve to protect the anode during the etching and manufacturing processes.

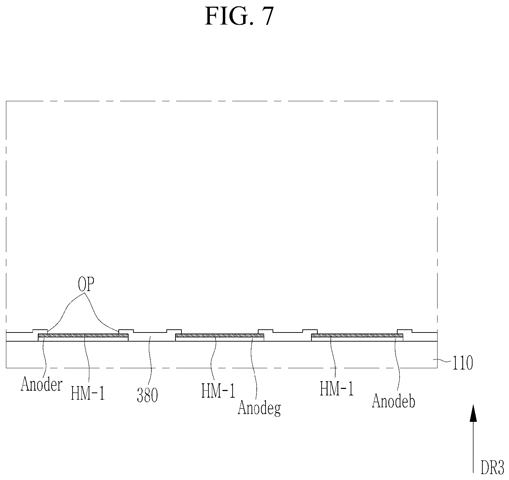

Then, referring to FIG. 7, the inorganic material for the inorganic pixel defining layer 380 is entirely stacked and then etched to form the inorganic pixel defining layer 380 having an opening OP. Here, the inorganic pixel defining layer 380 is located on the side of the anode and the side and top surfaces of the anode protective layer HM-1. The inorganic pixel defining layer 380 is located between an adjacent anode and the anode protective layer HM-1.

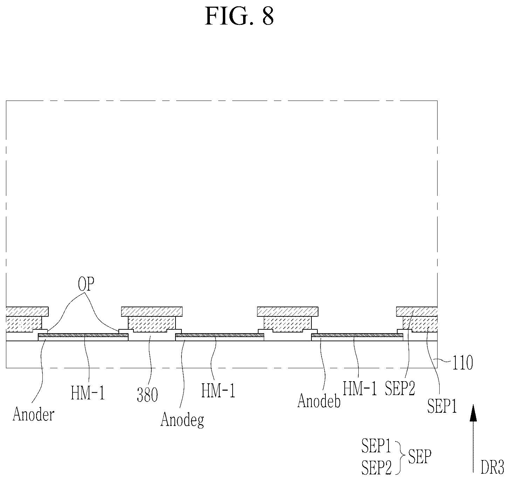

Thereafter, referring to FIG. 8, a lower separator SEP1 and an upper separator SEP2 are sequentially formed on the inorganic pixel defining layer 380. Specifically, a material for the lower separator SEP1 is stacked on the inorganic pixel defining layer 380 and the anode protective layer HM-1 and then etched to complete the lower separator SEP1. Thereafter, a material for the upper separator SEP2 is stacked on the lower separator SEP1, the inorganic pixel defining layer 380, and the anode protective layer HM-1 and then etched to complete the upper separator SEP2. Here, the upper separator SEP2 is formed to have a wider width than the lower separator SEP1 and has a protruding structure. Depending on the embodiment, the lower separator SEP1 and the upper separator SEP2 may be formed through a single etching process.

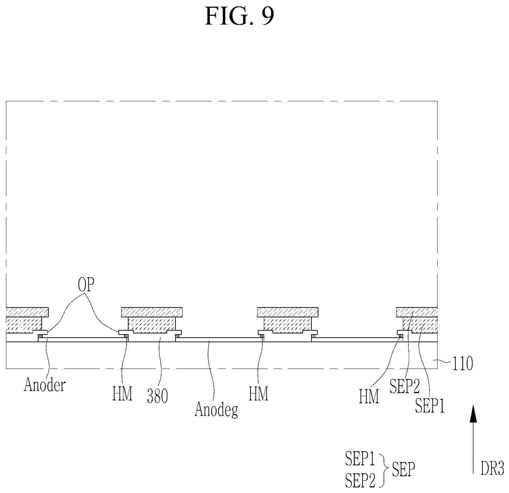

Thereafter, referring to FIG. 9, a part of the anode protective layer HM-1 that is exposed and not covered by the inorganic pixel defining layer 380 is etched to expose the anode. As a result, only a part of the anode protective layer HM-1 is left covered with the inorganic pixel defining layer 380, and the remaining anode protective layer HM is formed. The anode protective layer HM-1 protects the anode during the etching process to form the inorganic pixel defining layer 380, the lower separator SEP1, and the upper separator SEP2 after the anode is completed, and as there is no longer a need to protect the anode, the anode is exposed and changes to the remaining anode protective layer HM.

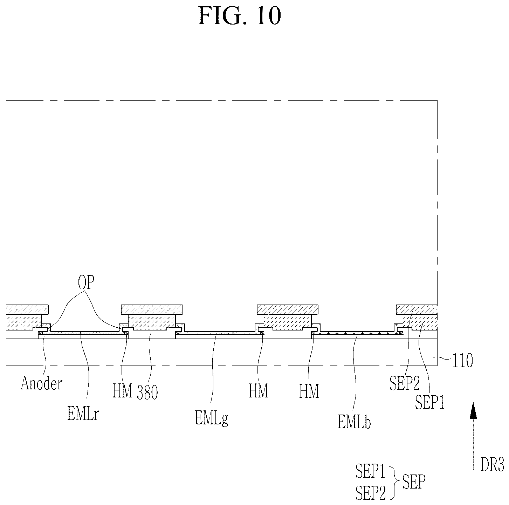

Thereafter, referring to FIG. 10, light emitting layers EMLr, EMLg, EMLb are formed on the exposed anode and the inorganic pixel defining layer 380. A part of the light emitting layers EMLr, EMLg, EMLb may be in contact with the side of the separator SEP, and FIG. 10 shows a structure in which the side of the lower separator SEP1 and the light emitting layers EMLr, EMLg, EMLb are in contact with each other. Functional layers (see functional layers FL in FIG. 25) may be located above and below the light emitting layers EMLr, EMLg, EMLb, and the light emitting layers EMLr, EMLg, EMLb and the functional layer can be combined to form a middle layer (see EL in FIG. 5). Here, the light emitting layers EMLr, EMLg, EMLb may be located in an empty space AC without contacting the remaining anode protective layer HM, as shown in FIG. 5. Afterwards, a cathode (see Cathode in FIG. 5) is formed on the light emitting layer EMLr, EMLg, EMLb to complete the light emitting diode. The structure of the cathode may be as shown in FIG. 5.

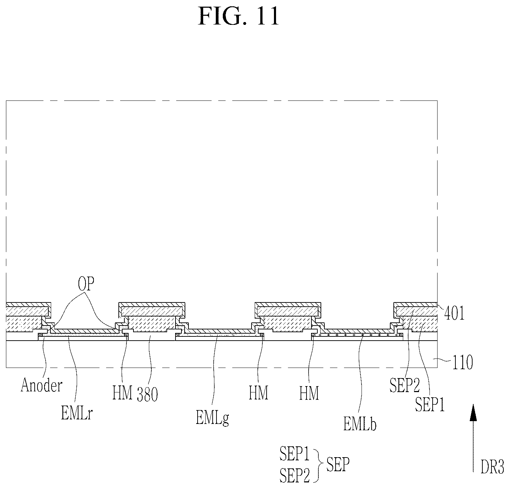

Thereafter, referring to FIG. 11, the lower inorganic encapsulation layer 401 among the encapsulation layers covering the light emitting diodes including the light emitting layers EMLr, EMLg, EMLb and the separator SEP is laminated. The lower inorganic encapsulation layer 401 is formed across the entire area, and is also formed on the step part between the lower separator SEP1 and the upper separator SEP2, and may have a structure that entirely covers the upper surface, the lower surface, and the side surface of the protruding part of the upper separator SEP2.

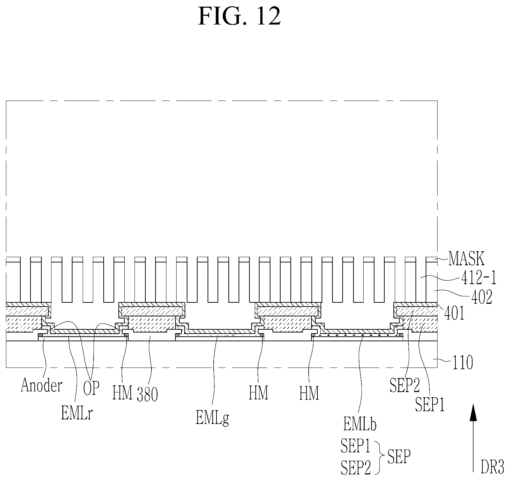

An organic encapsulation layer 402 including a plurality of light blocking structures 410 is formed on the lower inorganic encapsulation layer 401, and this will be examined in detail through FIGS. 12 to 17.

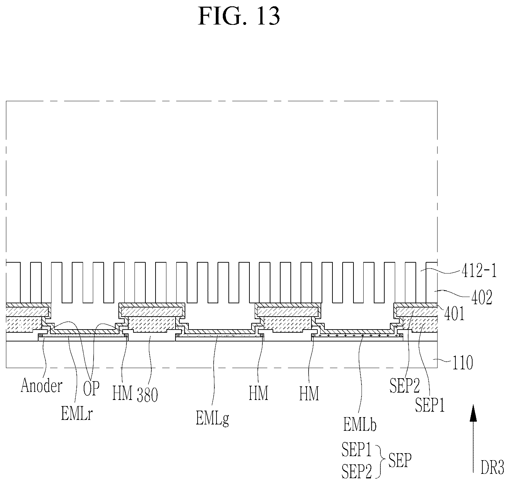

First, with reference to FIGS. 12 and 13, the steps for completing the organic encapsulation layer 402 by forming a trench 412-1 in the organic material for the organic encapsulation layer 402 will be separately examined.

Referring to FIG. 12, after sequentially stacking the organic material for the organic encapsulation layer 402 and the material for the hard mask on the lower inorganic encapsulation layer 401, the hard mask MASK is completed through an exposure process, and the material for the organic encapsulation layer 402 is etched according to the completed hard mask pattern to form the trench 412-1. Here, the hard mask MASK may be formed of a transparent conductive oxide, and the transparent conductive oxide may include IZO or IGZO. Depending on the embodiment, the hard mask MASK may be formed of a metal material other than transparent conductive oxide.

Then, referring to FIGS. 12 and 13, the hard mask MASK is removed to complete the organic encapsulation layer 402. Here, the trench 412-1 formed in the organic encapsulation layer 402 may correspond to the size of the light blocking structure described in FIG. 1. That is, the trench 412-1 may be formed to have a height of 4 µm to 12 µm, a width of 1 µm to 2 µm, and a pitch of 0.1 µm to 20 µm. The gap between the adjacent trenches 412-1 can be 1 µm or more, and the gap value can be adjusted according to the viewing angle to be blocked through the trenches 412-1. Additionally, in an embodiment, the width of the trench 412-1 and the ratio of the gap between adjacent trenches 412-1 can be formed as 1:4, and the gap between the trenches 412-1 can be formed to be more than four times the width of the trench 412-1.

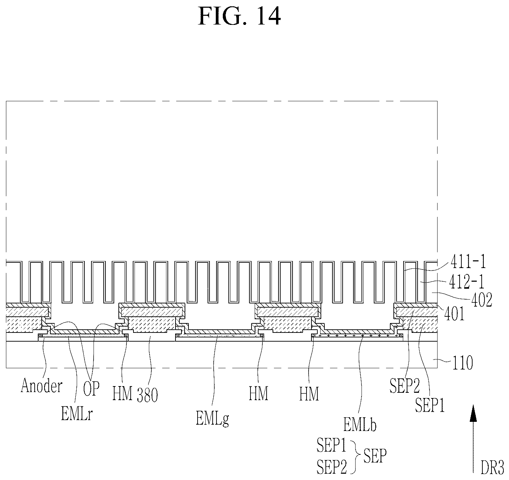

Thereafter, referring to FIG. 14, a barrier layer material 411-1 is entirely laminated on the upper surface of the organic encapsulation layer 402 and the inner surface of the trench 412-1. Here, the barrier layer material 411-1 may be formed of a material containing metal oxide, examples of which may be TiO₂, Al₂O₃, SiO₂, and Fe₂O₃. The barrier layer material 411-1 may be formed of a metal oxide material through chemical vapor deposition CVD or atomic layer deposition ALD. Among these, using the atomic layer deposition method allows the deposited barrier layer material 411-1 to have good step coverage, so it can be continuously formed without interruption even if there are steps, and can be formed throughout the inside of the trench 412-1 of the organic encapsulation layer 402. Additionally, the barrier layer material 411-1 contains metal oxide, thus it also has reflective properties, so it has a total reflection property and consequently the barrier layer 411 is also referred to as a low-reflection layer, and the low-reflection characteristics of the barrier layer 411 may prevent light emitted from the light emitting diode from being reflected and not being emitted to the front.

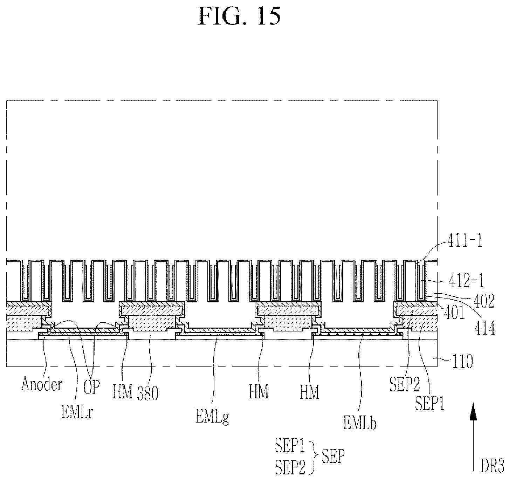

Thereafter, referring to FIG. 15, a hydrophobic coating layer 414 is formed on a part of the barrier layer material 411-1 located within the trench 412-1. The hydrophobic coating layer 414 according to an embodiment may be formed through the following process. First, resin is formed at the entrance of the trench 412-1 among the barrier layer material 411-1. Here, the resin can be cured with ultraviolet rays, and the resin can be completed by curing with ultraviolet rays. Then, a hydrophobic coating layer is formed over the entire area, wherein the hydrophobic coating layer may be formed using a conformal coating method. Afterwards, the exposed surface is subjected to plasma treatment to remove the resin. The result, as shown in FIG. 15, is the hydrophobic coating layer 414 which is located only inside, except for the entrance part of the trench 412-1. That is, the part in FIG. 15 where the hydrophobic coating layer 414 is not located may correspond to a part where resin was formed and then removed.

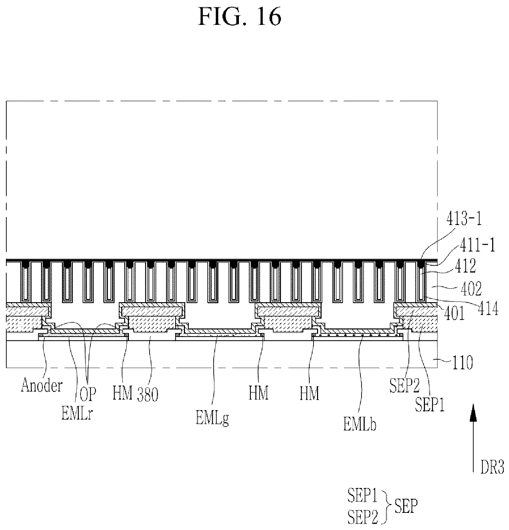

Thereafter, referring to FIG. 16, the capping part material 413-1 is formed over the entire area, and the capping part material 413-1 may be applied and then cured with ultraviolet rays. Specifically, the capping part material 413-1 is formed on the barrier layer material 411-1 located on the upper surface of the organic encapsulation layer 402 and at the entrance of the trench 412-1. At this time, the capping part material 413-1 is not entirely formed within the trench 412-1, and some of the capping part material 413-1 is formed only at the entrance, which is formed as a hydrophobic coating layer 414 for the capping part, and this may be because the capping part material 413-1 does not flow into the trench 412-1. As a result, one end of the capping part 413 and one end of the hydrophobic coating layer 414 may have structures in contact with each other. As the capping part material 413-1 is formed, the trench 412-1 is changed into a space 412 that is separated from other parts, and the space 412 is filled with air. Here, the capping part material 413-1 may be made of a material that can block light. That is, the capping part material 413-1 may be formed of the same material as the light blocking layer (black matrix) and may be formed of an organic material containing black pigment. Here, an example of a material that can block light is a substance that induces a chemical change when irradiated with light (photoresist), and as black pigments, it may include carbon black, carbon nanotubes, resin or paste containing black dye, metal particles such as nickel, aluminum, molybdenum, and their alloys, and metal oxide particles (for example, chromium nitride). Depending on the embodiment, the capping part material 413-1 may be made of a transparent material that does not block light, or may be made of a colored material that has a specific color other than black.

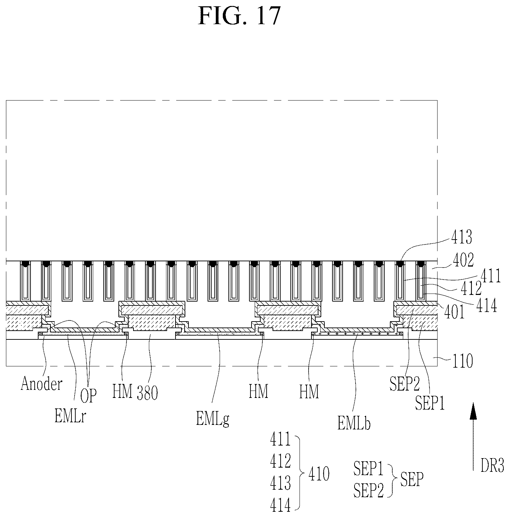

Thereafter, referring to FIG. 17, the capping part material 413-1 and the barrier layer material 411-1 are removed through a dry etching process, and the upper surface of the organic encapsulation layer 402 is exposed. At this time, the capping part material 413-1 is etched to complete the plurality of capping parts 413. One capping part 413 is formed in each trench.

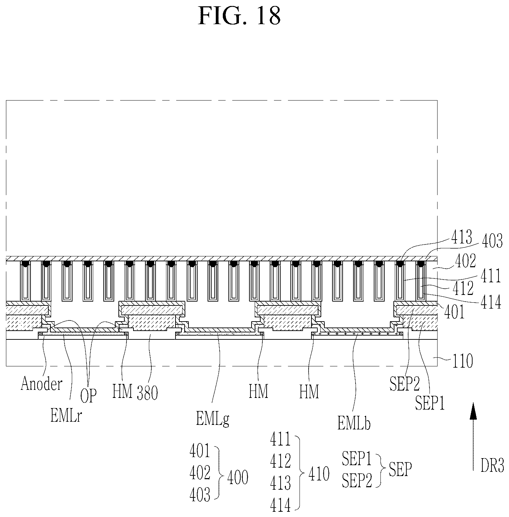

Then, referring to FIG. 18, the organic encapsulation layer 402 and the upper inorganic encapsulation layer 403 covering the capping part 413 of the light blocking structure 410 are stacked. As a result, the encapsulation layer 400 is completed, which includes the lower inorganic encapsulation layer 401, the organic encapsulation layer 402, and the upper inorganic encapsulation layer 403, with a plurality of light blocking structures 410 formed within the organic encapsulation layer 402. The encapsulation layer 400, which includes the lower inorganic encapsulation layer 401, the organic encapsulation layer 402, and the upper inorganic encapsulation layer 403, prevents moisture or air from entering the light emitting layers EMLr, EMLg, EMLb. To prevent the problem of deterioration of encapsulation properties due to the light blocking structure 410 being formed on the organic encapsulation layer 402, a hydrophobic coating layer 414 may be additionally formed within the light blocking structure 410. In addition, to prevent moisture or air from entering the additional light emitting layers EMLr, EMLg, EMLb, a triple-layer structure consisting of the lower inorganic encapsulation layer 401, the separator SEP, and the inorganic pixel defining layer 380 is also formed. That is, by forming the double-layered separator SEP made of metal between the inorganic pixel defining layer 380 and the lower inorganic encapsulation layer 401 formed of inorganic material, a layered structure containing metal can be formed between the inorganic layers formed by chemical vapor deposition, further blocking the influx of moisture or air from the outside.

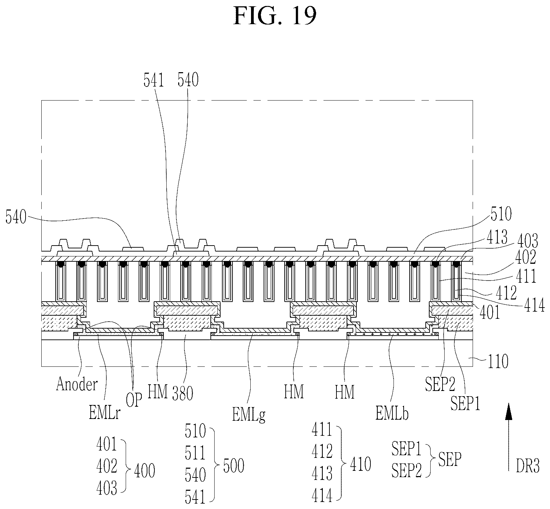

Afterwards, referring to FIG. 19, a touch sensing layer 500 may be formed on the upper inorganic encapsulation layer 403. The touch sensing layer 500 may include sensing insulating layers 510, 511 and multiple sensing electrodes 540, 541, and the touch sensing layer 500 can sense touch using the capacitive method with the two sensing electrodes 540, 541. FIG. 19 shows a plurality of sensing electrodes 540 and 541 on the upper inorganic encapsulation layer 403 of the encapsulation layer 400 and a sensing insulating layer 510 for insulation between the two conductive layers. Depending on the embodiment, the touch sensing layer 500 may have various structures.

In the above, a method of manufacturing a part of the light emitting display device according to the embodiment of FIG. 1 was sequentially examined through FIGS. 6 to 19.

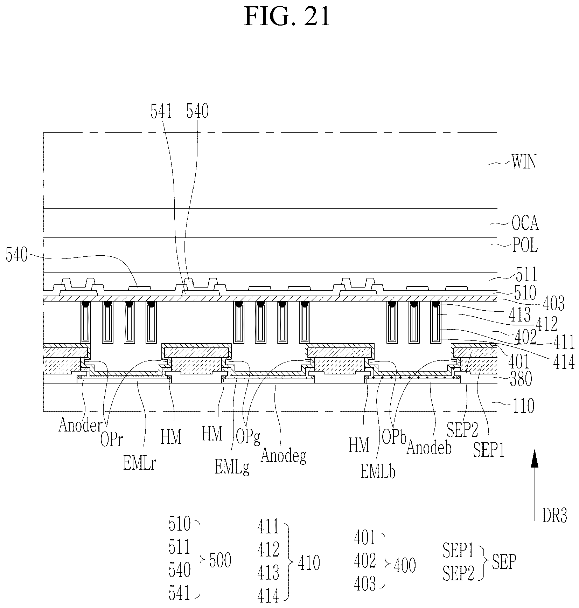

However, depending on the embodiment, the light emitting display device may be formed with a structure that is at least partially different from the light emitting display device of FIG. 1, so hereinafter, some of the structures of the modified embodiment will be looked at through FIGS. 20 and 21.

FIG. 20 and FIG. 21 are cross-sectional views schematically showing a light emitting display device according to an embodiment.

First, the embodiment of FIG. 20 will be examined.

In the embodiment of FIG. 20, unlike the embodiment of FIG. 1, the capping part 413-a of the light blocking structure 410 is not black and has a structure capable of transmitting at least a part of the incident light.

Referring to the embodiment of FIG. 20, the capping part 413-a of the light blocking structure 410 may be formed of a colored organic material or a transparent organic material. If the capping part 413-a is made of a colored organic material or a transparent organic material, at least some of the light incident on the capping part 413-a may be at least partially transmitted. As a result, the light blocking effect of the light blocking structure 410 may be lower compared to the embodiment of FIG. 1. However, referring to FIG. 20, the light blocking structure 410 is formed in a plurality, and the light traveling laterally enters the capping part 413-a of the light blocking structure 410 after passing through at least a plurality of light blocking structures 410, so the amount of light entering the capping part 413-a is not large, and therefore, even if the capping part 413-a does not block the light, the effect of the light blocking structure 410 in blocking light does not significantly increase. Therefore, as in the embodiment of FIG. 20, the capping part 413-a may be formed of a colored organic material or a transparent organic material. Depending on the embodiment, if the light blocking structure 410 requires higher light blocking efficiency, the capping part 413 may be formed using a black organic material as shown in FIG. 1.

Below, we will look at the embodiment of FIG. 21.

In the embodiment of FIG. 21, unlike the embodiment of FIG. 1, the light blocking structure 410 is formed only in the area that overlaps the light emitting layers EMLr, EMLg, EMLb, and does not form the light blocking structure 410 in the area overlapping only the separator SEP. In the embodiment of FIG. 1, the light blocking structure 410 located in an area that overlaps only the actual separator SEP does not play a significant role in blocking light traveling laterally, so even if formed as in the embodiment of FIG. 21, light traveling laterally does not occur, since the amount of light does not increase significantly, the light blocking structure 410 may not be formed in some areas as shown in FIG. 21. Depending on the embodiment, unlike FIG. 21, the light blocking structure 410 may be additionally formed in an area that overlaps only a part of the separator SEP to further block light traveling laterally. In addition, in the embodiment of FIG. 21, the capping part 413 may be formed of a colored organic material or a transparent organic material, as in the embodiment of FIG. 20.

The manufacturing method of FIGS. 6 to 19 may be similarly applied to the embodiments of FIGS. 20 and 21.

The modified embodiments of FIGS. 20 and 21 are some of the embodiments of the present disclosure, and modifications other than those of FIGS. 20 and 21 are also possible.

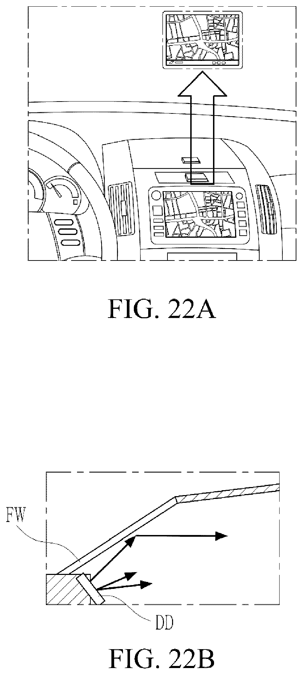

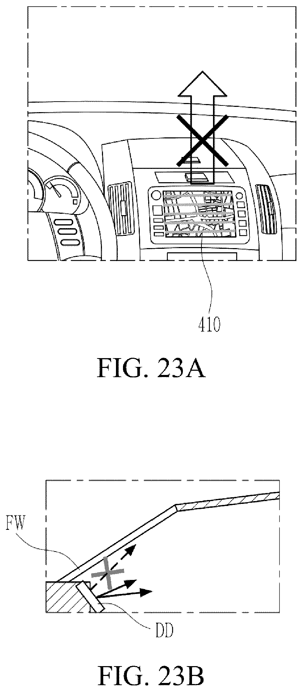

The effect that a light emitting display device having the above structure and formed through a manufacturing method may have when applied to a vehicle will be examined through FIG. 23 while comparing it with the comparative example of FIG. 22.

FIGS. 22A, 22B are a diagram showing a case where a light emitting display device according to a comparative example is applied to a vehicle, and FIGS. 23A, 23B are a diagram showing a case where a light emitting display device according to an embodiment is applied to a vehicle.

In the comparative example of FIGS. 22A, 22B, the light emitting display device DD used in vehicles does not include a light blocking structure 410, and as shown in FIG. 22B, the angle of the emitted light is not limited and is emitted in various directions.

In contrast, in the embodiment of FIGS. 23A, 23B, the light emitting display device DD used in a vehicle includes a plurality of light blocking structures 410 arranged in one direction (the horizontal direction) to partially block light emitted in the vertical direction. At this time, light that is more than 30 degrees from a normal line perpendicular to the front of the light emitting display device DD may be blocked.

Referring to FIGS. 22A, 22B, the light emitted from the light emitting display device DD located in the center fascia of the vehicle is also provided to the front glass FW of the vehicle, and at night, the light emitted from the light emitting display device DD may be reflected by the front glass FW and reach the driver's eyes, which may cause a problem by obstructing the driver's view.

In contrast, referring to FIGS. 23A, 23B, the light emitting display device DD used in vehicles has multiple light blocking structures 410 to prevent light emitted from the light emitting display device DD from being transmitted to the vehicle's front glass FW, thereby preventing reflection from the front glass FW at night and not obstructing the driver's view.

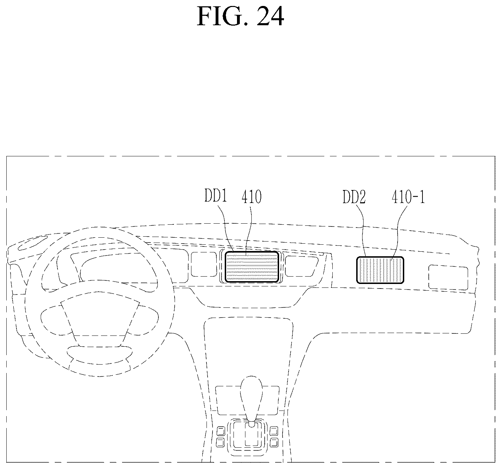

Depending on the embodiment, the arrangement direction of the light emitting display device DD and the plurality of light blocking structures 410 used in the vehicle may vary, and an embodiment will be examined through FIG. 24.

FIG. 24 is a diagram illustrating a case where a light emitting display device is applied to a vehicle according to an embodiment.

The vehicle according to the embodiment of FIG. 24 is equipped with two light emitting display devices DD1 and DD2.

The first light emitting display device DD1 is located in the center fascia as shown in FIG. 24 and has a plurality of light blocking structures 410 arranged in the horizontal direction. Here, the first light emitting display device DD1 may have a structure described with respect to Fig. 1 to 3 and 5. The elements included in the first light emitting display device DD1 may refer to first elements. For example, the first light emitting display device DD1 includes a first substrate, a first light emitting layer, a first encapsulation layer and so on. As a result, light is not reflected from the front glass and does not interfere with the driver's view.

The second light emitting display device DD2 is located in front of the passenger seat and has a plurality of light blocking structures 410-1 arranged in the vertical direction. Due to the plurality of light blocking structures 410-1 arranged in the vertical direction, the light emitted from the second light emitting display device DD2 is not provided in the left and right directions, so only the person sitting in the passenger seat may see the screen of the second light emitting display device DD2, and the driver may not see the screen of the second light emitting display device DD2. As a result, there is an advantage in that the driver may focus on driving without paying attention to the second light emitting display device DD2. The second light emitting display device DD2 may have a structure described with respect to Fig. 1 to 3 and 5. The elements included in the second light emitting display device DD2 may refer to second elements. For example, the second light emitting display device DD2 includes a second substrate, a second light emitting layer, a second encapsulation layer and so on.

In the above, the light blocking structure 410 and its surrounding structure and manufacturing method along with the schematic structure of the light emitting display device was examined in detail.

Hereinafter, the structure of the light emitting diode and the pixel circuit unit that provides current to the light emitting diode will be examined in more detail through FIG. 25.

FIG. 25 is a diagram illustrating a cross-sectional structure of a light emitting display device according to an embodiment.

FIG. 25 shows a stacked structure of pixels located in the display area of a light emitting display device.

A light emitting display device may be largely divided into a lower panel layer and an upper panel layer, the lower panel layer is where the light emitting diodes and pixel circuitry that make up the pixels are located, and may even include an encapsulation layer 400 that covers it. Here, the pixel circuitry includes a second organic layer 182 and a third organic layer 183, which refer to its lower components, and the light emitting diode is above the third organic layer 183 and may refer to a configuration located beneath the encapsulation layer 400. A plurality of light blocking structures 410 may be formed in the organic encapsulation layer 402 of the encapsulation layer 400. The structure located on top of the encapsulation layer 400 may correspond to the upper panel layer, and the touch sensing layer 500 for touch sensing may be included in the upper panel layer. Depending on the embodiment, the third organic layer 183 may not be included.

Referring to FIG. 25, a metal layer BML is located on the substrate 110.

The substrate 110 may include a material that has rigid properties and does not bend, such as glass, or may include a flexible material that can bend, such as plastic or polyimide. In the case of a flexible substrate, as shown in FIG. 25, it may have a double-layer structure of polyimide and a barrier layer formed of an inorganic insulating material thereon.

The metal layer BML may be formed in a position that overlaps the channel of the driving transistor in a plane of the subsequent first semiconductor layer ACT (P-Si), and is also called a lower shielding layer. The metal layer (BML) may include a metal or metal alloy such as copper (Cu), molybdenum (Mo), aluminum (Al), or titanium (Ti). Here, the driving transistor may refer to a transistor that generates current to be transmitted to the light emitting diode.

A buffer layer 111 covering the substrate 110 and the metal layer BML is located on the substrate. The buffer layer 111 serves to block the penetration of impurities into the first semiconductor layer ACT (P-Si), and may be an inorganic insulating layer that includes silicon oxide SiOx, silicon nitride SiNx, or silicon oxynitride SiONx.

The first semiconductor layer ACT1 (P-Si) formed of a silicon semiconductor (e.g., polycrystalline semiconductor (P-Si)) is located on the buffer layer 111. The first semiconductor layer ACT1 (P-Si) includes a channel of a polycrystalline transistor LTPS TFT including a driving transistor, and a first region and a second region located on both sides of the channel. Here, the polycrystalline transistor LTPS TFT may include various switching transistors as well as a driving transistor. In addition, the first semiconductor layer ACT1 (P-Si) has regions on both sides of the channel that have conductive layer characteristics through plasma treatment or doping, and can serve as the first and second electrodes of the transistor.

A first gate insulating layer 141 may be located on the first semiconductor layer ACT1 (P-Si). The first gate insulating layer 141 may be an inorganic insulating layer containing silicon oxide SiOx, silicon nitride SiNx, or silicon oxynitride SiONx.

A first gate conductive layer including a gate electrode GAT1 of the polycrystalline transistor LTPS TFT may be located on the first gate insulating layer 141. The first gate conductive layer may include a scan line or an emission control line in addition to the gate electrode GAT1 of the polycrystalline transistor LTPS TFT. The first gate conductive layer may include a metal or metal alloy such as copper (Cu), molybdenum (Mo), aluminum (Al), or titanium (Ti), and may be composed of a single layer or multiple layers.

After forming the first gate conductive layer, a plasma treatment or doping process may be performed to make the exposed area of the first semiconductor layer conductive. That is, the first semiconductor layer ACT1 (P-Si) covered by the first gate conductive layer is not conductive, and the part of the first semiconductor layer ACT1 (P-Si) not covered by the first gate conductive layer may have the same characteristics as the conductive layer.

A second gate insulating layer 142 may be located on the first gate conductive layer and the first gate insulating layer 141. The second gate insulating layer 142 may be an inorganic insulating layer containing silicon oxide SiOx, silicon nitride SiNx, or silicon oxynitride SiONx.

A second gate conductive layer including one electrode GAT2 (Cst) of the storage capacitor Cst and the lower shielding layer GAT2 (BML) of the oxide transistor Oxide TFT may be located on the second gate insulating layer 142. The lower shielding layer GAT2 (BML) of the oxide transistor Oxide TFT is located at the bottom of the channel of each oxide transistor Oxide TFT, and serves to shield the channel from light or electromagnetic interference provided to the channel from the bottom. One electrode GAT2 (Cst) of the storage capacitor (Cst) overlaps the gate electrode GAT1 of the driving transistor to form the storage capacitor (Cst). Depending on the embodiment, the second gate conductive layer may further include a scan line, a control line, or a voltage line. The second gate conductive layer may include a metal or metal alloy such as copper (Cu), molybdenum (Mo), aluminum (Al), or titanium (Ti), and may be composed of a single layer or multiple layers.

A first interlayer insulating layer 161 may be located on the second gate conductive layer. The first interlayer insulating layer 161 may include an inorganic insulating layer comprising silicon oxide SiOx, silicon nitride SiNx, silicon oxynitride SiONx, etc., and in some embodiments, a thick inorganic insulating material may be formed.

An oxide semiconductor layer ACT2 (IGZO), also referred to as a second semiconductor layer, including a channel, a first region, and a second region of the oxide transistor Oxide TFT may be located on the first interlayer insulating layer 161.

A third gate insulating layer 143 may be located on the oxide semiconductor layer ACT2 (IGZO). The third gate insulating layer 143 may be located on the entire surface of the oxide semiconductor layer ACT2 (IGZO) and the first interlayer insulating layer 161. The third gate insulating layer 143 may include an inorganic insulating layer containing silicon oxide SiOx, silicon nitride SiNx, or silicon oxynitride SiONx.

A third gate conductive layer GAT3 including the gate electrode of the oxide transistor Oxide TFT may be located on the third gate insulating layer 143. The gate electrode of the oxide transistor Oxide TFT may overlap the channel. The third gate conductive layer GAT3 may further include a scan line or a control line. The third gate conductive layer may include a metal or metal alloy such as copper (Cu), molybdenum (Mo), aluminum (Al), or titanium (Ti), and may be composed of a single layer or multiple layers.

A second interlayer insulating layer 162 may be located on the third gate conductive layer GAT3. The second interlayer insulating layer 162 may be composed of a single layer or multiple layers. The second interlayer insulating layer 162 may include an inorganic insulating material such as silicon nitride SiNx, silicon oxide SiOx, or silicon nitride SiOxNy, and may include an organic material depending on the embodiment.

A first data conductive layer SD1 may be located on the second interlayer insulating layer 162 and may include a connection electrode that can be connected to the first and second regions of each of the polycrystalline transistor LTPS TFT and the oxide transistor Oxide TFT. The first data conductive layer SD1 may include a metal or metal alloy such as aluminum (Al), copper (Cu), molybdenum (Mo), titanium (Ti), and may be composed of a single layer or multiple layers.

The first organic layer 181 may be located on the first data conductive layer SD1. The first organic layer 181 may be an organic insulating layer containing an organic material, and the organic material may include one or more materials selected from the group consisting of polyimide, polyamide, acrylic resin, benzocyclobutene, and phenol resin.

A second data conductive layer including an anode connection electrode ACM2 may be located on the first organic layer 181. The second data conductive layer may include a data line or a driving voltage line. The second data conductive layer may include a metal or metal alloy such as aluminum (Al), copper (Cu), molybdenum (Mo), or titanium (Ti), and may be composed of a single layer or multiple layers. The anode connection electrode ACM2 may be connected to the first data conductive layer SD1 through an opening OP3 located in the first organic layer 181.

The second organic layer 182 and the third organic layer 183 are located above the second data conductive layer, and an opening OP4 for anode connection is formed in the second organic layer 182 and the third organic layer 183. The anode connection electrode ACM2 is electrically connected to the anode Anode through the anode connection opening OP4. The second organic layer 182 and the third organic layer 183 may be organic insulating layers and may include one or more materials selected from the group consisting of polyimide, polyamide, acrylic resin, benzocyclobutene, and phenol resin. Depending on the embodiment, the third organic layer 183 may be omitted.

An inorganic pixel defining layer 380 may be located on the anode Anode and may have an opening OP exposing the anode Anode and covering at least a part of the anode Anode. The inorganic pixel defining layer 380 may be a black pixel defining layer formed from a black organic material to prevent light applied from the outside from being reflected back to the outside, and according to an embodiment, it may also be formed from a transparent organic material.

A double layer of the separators SEP1 and SEP2 may be formed on the inorganic pixel defining layer 380. The lower separator SEP1 and the upper separator SEP2 are each formed including metals or metal alloys, and the width of the upper separator SEP2 is formed wider than that of the lower separator SEP1, resulting in a structure where both ends of the upper separator SEP2 protrude above the surface of the lower separator SEP1.

The inorganic pixel defining layer 380, the double layer of the separators SEP1, SEP2, and the functional layer FL and the cathode are sequentially stacked on top of the anode, with the functional layer FL and the cathode being separated by the separators SEP1, SEP2, and the separation middle layer EL-1 and the separating cathode Cathode-1 are formed above the upper separator SEP2. The light emitting layer EML may be located between the functional layers FL, and the light emitting layer EML may be located only within the opening OP of the inorganic pixel defining layer 380. Therefore, the separation middle layer EL-1 may be formed only from the functional layer FL. The functional layer FL and the light emitting layer EML may be combined to form a middle layer (see EL in FIG. 5). The functional layer FL may include at least one auxiliary layer such as an electron injection layer, an electron transport layer, a hole transport layer, and a hole injection layer, with the hole injection layer and the hole transport layer located beneath the light emitting layer EML, and the electron transport layer and electron injection layer located above the light emitting layer EML.

The encapsulation layer 400 is located on the cathode and the separation cathode Cathode-1. The encapsulation layer 400 includes at least one inorganic layer and at least one organic layer, and has a triple-layer structure including a lower inorganic encapsulation layer 401, an organic encapsulation layer 402, and an upper inorganic encapsulation layer 403. The organic encapsulation layer 402 includes multiple light blocking structures 410, and the light blocking structure 410 includes the barrier layer 411, the space 412, and the capping part 413, and may additionally include a hydrophobic coating layer 414 on the inside of the barrier layer 411. The encapsulation layer 400 is designed to protect the light emitting layer EML from moisture and oxygen that may enter from the outside. Although the thickness of the organic encapsulation layer 402 may be reduced in some parts due to the light blocking structure 410 located in the organic encapsulation layer 402, it can prevent moisture from passing through the thin part of the organic encapsulation layer 402 to the light emitting layer EML by having the hydrophobic coating layer 414 inside.

The touch sensing layer 500 for touch sensing is located on the encapsulation layer 400, and the touch sensing layer 500 includes the sensing insulating layers 501, 510, 511 and a plurality of sensing electrodes 540, 541. In the embodiment of FIG. 25, touch can be sensed in a capacitive manner using the two sensing electrodes 540, 541.

Specifically, a first sensing insulating layer 501 may be formed on the encapsulation layer 400, and a plurality of sensing electrodes 540, 541 are formed thereon. The plurality of sensing electrodes 540, 541 may be insulated with the second sensing insulating layer 510 interposed therebetween, and some of them may be electrically connected through an opening located in the second sensing insulating layer 510. Here, the sensing electrodes 540, 541 may include metals or metal alloys such as aluminum (Al), copper (Cu), silver (Ag), gold (Au), molybdenum (Mo), titanium (Ti), tantalum (Ta), and can be composed of either a single layer or multiple layers. The third sensing insulating layer 511 is formed on the sensing electrode 540.

A planarization layer 530 may be further included on the third sensing insulating layer 511.

As shown in FIG. 1, a polarizing plate POL, an adhesive layer OCA, and a cover window WIN may be sequentially located on the planarization layer 530.

In FIG. 25, an embodiment in which a total of three organic layers are formed and an anode connection opening is formed in the second organic layer and the third organic layer is examined. However, at least two organic layers may be formed, and in this case, the anode connection opening may be located in the upper organic layer located away from the substrate, and the lower organic layer opening may be located in the lower organic layer.

Although the embodiments of the present disclosure have been described in detail above, the scope of the present disclosure is not limited thereto, and various modifications and improvements made by those skilled in the art using the basic concepts of the present disclosure defined in the following claims are also possible.

**<Description of symbols>**

| | | | |
|---|---|---|---|
| DD, DD1, DD2: | light emitting display device | | |
| Anode, Anoder, Anodeg, Anodeb: | anode | | |
| Cathode: | cathode | 380: | inorganic pixel defining layer |
| OP, OPr, OPg, OPb: | opening of inorganic pixel defining layer | | |
| SEP, SEP1, SEP2: | separator | OP-SEP: | opening of the separator |
| 400: | encapsulation layer | 401: | lower inorganic encapsulation layer |
| 402: | organic encapsulation layer | 403: | upper inorganic encapsulation layer |
| 410, 410-1: | light blocking structure | | |
| 411: | barrier layer | 412: | space |
| 412-1: | trench | 413, 413-a: | capping part |
| 414: | hydrophobic coating layer | | |
| AC: | empty space | EL: | middle layer |
| Cathode-1: | separation cathode | EL-1: | separation middle layer |
| EML, EMLr, EMLg, EMLb: | light emitting layer | | |
| FL: | functional layer | HM, HM-1: | anode protective layer |
| MASK: | hard mask | 501, 510, 511: | sensing insulating layer |
| 540, 541: | sensing electrode | 411-1: | barrier layer material |
| 413-1: | capping material | POL: | polarizer |
| OCA: | adhesive layer | WIN: | cover window |
| FW: | front glass | LCF: | light control film |
| 110: | substrate | 111: | buffer layer |
| 141, 142, 143: | gate insulating layer | | |
| 161, 162: | interlayer insulating layer | | |
| 181, 182, 183: | organic layer | 530: | flattening layer |
| OP3, OP4: | opening | BML: | metal layer |
| GAT1: | gate electrode | GAT2 (BML): | lower shielding layer |
| GAT2 (Cst): | one electrode of storage capacitor | | |
| SD1: | first data conductive layer | ACM2: | anode connection electrode |
| ACT1 (P-Si): | first semiconductor layer | | |
| ACT2 (IGZO): | oxide semiconductor layer | | |
| LTPS TFT: | polycrystalline transistor | | |
| Oxide TFT: | oxide transistor | | |

## Claims

1. A light emitting display device, comprising:
a substrate (110);
a light emitting layer (EMLr, EMLg, EMLb ) disposed on the substrate; and
an encapsulation layer (400) covering the light emitting layer and including a lower inorganic encapsulation layer (401), an organic encapsulation layer (402), and an upper inorganic encapsulation layer (403);
wherein the organic encapsulation layer (402) includes a plurality of light blocking structures extending longitudinally in one direction in an area overlapping the light emitting layer, and
each of the plurality of light blocking structures (410) includes a barrier layer (411), a capping layer (413), and a space (412) filled by an air and surrounded by the barrier layer and the capping layer.

2. The light emitting display device of claim 1, wherein:
the barrier layer (411) includes one of TiO₂, Al₂O₃, SiO₂, and Fe₂O₃ and has low-reflection characteristics, and/or, wherein:
each of the plurality of light blocking structures (410) further includes a hydrophobic coating layer (414) disposed inside the barrier layer (411).

3. The light emitting display device of claim 2, wherein:
the hydrophobic coating layer (414) and the capping layer (413) are in contact with each other.

4. The light emitting display device of any of the preceding claims, wherein:
the capping layer (413) includes a material having a black color, a specific color, or being transparent, and/or wherein:
the plurality of light blocking structures (410) are disposed only in areas overlapping the light emitting layer.

5. The light emitting display device of any of the preceding claims, wherein:
each of the plurality of light blocking structures (410) has a height of 4 µm or more and 12 µm or less, a width of 1 µm or more and 2 µm or less, and
a gap between two adjacent light blocking structures of the plurality of light blocking structures (410) is 1 µm or more.

6. The light emitting display device of claim 5, wherein:
the gap between the two adjacent light blocking structures (410) is at least four times greater than the width of each of the plurality of light blocking structures (410).

7. The light emitting display device of any of the preceding claims, further comprising:
an anode disposed between the substrate and the light emitting layer;
an inorganic pixel defining layer having an opening corresponding to the light emitting layer;
a separator disposed on the inorganic pixel defining layer and including a lower separator including a metal and an upper separator; and
a cathode disposed on the light emitting layer,
wherein the upper separator includes a structure that protrudes more than the lower separator.

8. The light emitting display device of claim 7, further comprising:
a separation cathode disposed above the upper separator;
a plurality of cathodes including the cathode; and
a plurality of light emitting layers comprising the light emitting layer,
wherein adjacent cathodes of the plurality of cathodes disposed on adjacent light emitting layers of the plurality of light emitting layers are electrically connected by the lower separator or the upper separator, and/or, further comprising:
an anode protective layer disposed between the inorganic pixel defining layer and the anode.

9. A method of manufacturing a light emitting display device, comprising:
laminating a lower inorganic encapsulation layer (400) covering a light emitting layer disposed on a substrate;
forming an organic encapsulation layer (400) disposed on the lower inorganic encapsulation layer and including a plurality of light blocking structures (410, 410-1) extending in one direction; and
laminating an upper inorganic encapsulation layer covering the plurality of light blocking structures (410, 410-1) and the organic encapsulation layer,
wherein the forming of the organic encapsulation layer including the plurality of light blocking structures (410, 410-1) includes:
stacking and etching organic materials to form the organic encapsulation layer (402) having a plurality of trenches;
laminating a barrier layer material on an upper surface of the organic encapsulation layer (402) and an inner surface of the plurality of trenches;
forming a capping part material on the barrier layer material disposed on the upper surface of the organic encapsulation layer (402) and at an entrance of the plurality of trenches; and
exposing the upper surface of the organic encapsulation layer (402) by removing the capping part material and the barrier layer material.

10. The method of manufacturing a light emitting display device of claim 9, further comprising:
forming a hydrophobic coating layer (414) on a part of the barrier layer material disposed in the plurality of trenches between the step of laminating the barrier layer material and the step of forming the capping part material, and/or wherein:
the barrier layer (411) includes one of TiO₂, Al₂O₃, SiO₂, and Fe₂O₃, and has low-reflection characteristics.

11. The method of manufacturing a light emitting display device of claim 9 or 10, further comprising:
before laminating the lower inorganic encapsulation layer (401),
forming an anode and an anode protective layer by sequentially stacking an anode material and an anode protective layer material on the substrate;
forming an inorganic pixel defining layer having an opening exposing the anode protective layer;
forming a separator including a lower separator and an upper separator on the inorganic pixel defining layer;
exposing the anode by etching the exposed anode protective layer; and
forming the light emitting layer on the exposed anode,
wherein the upper separator has a structure in which the upper separator protrudes more than the lower separator.

12. A vehicle comprising:
a first light emitting display device (DD1),
the first light emitting display device (DD1) comprising:
a first substrate (110);
a first light emitting layer (EMLr, EMLg, EMLb ) disposed on the first substrate; and
a first encapsulation layer (400) covering the first light emitting layer and including a first lower inorganic encapsulation layer (401), a first organic encapsulation layer (402), and a first upper inorganic encapsulation layer (403),
wherein the first organic encapsulation layer (400) includes a plurality of first light blocking structures (410) in an area overlapping the first light emitting layer, and
each of the plurality of first light blocking structures (410) includes a first barrier layer (411), a first capping layer (413), and a first space filled by an air and surrounded by the first barrier layer (411) and the first capping layer (413).

13. The vehicle of claim 12, further comprising:
a second light emitting display device (DD2),
the second light emitting display device (DD2) comprising:
a second substrate (110);
a second light emitting layer (EMLr, EMLg, EMLb ) disposed on the second substrate; and
a second encapsulation layer (400) covering the second light emitting layer and including a second lower inorganic encapsulation layer (401), a second organic encapsulation layer (402), and a second upper inorganic encapsulation layer (403),
wherein the second organic encapsulation layer (400) includes a plurality of second light blocking structures (410) in an area overlapping the second light emitting layer, and
each of the plurality of second light blocking structures includes a second barrier layer (411), a second capping layer (413), and a second space filled by the air and surrounded by the second barrier layer (411) and the second capping layer (413).

14. The vehicle of claim 12 or 13, wherein:
the plurality of first light blocking structures (410) extend in a first direction, and
the plurality of second light blocking structures (410) extend in a direction intersecting the first direction, and/or wherein:
each of the plurality of first light blocking structures (410) further includes a first hydrophobic coating layer (414) disposed inside the first barrier layer or each of the plurality of second light blocking structures (410) further includes a second hydrophobic coating layer (414) disposed inside the second barrier layer.

15. The vehicle claim any of claims 12 to 14, wherein:
each of the plurality of first light blocking structures (410) or the plurality of second light blocking structures (410) has a height of 4 µm or more and 12 µm or less, a width of 1 µm or more and 2 µm or less, and
a gap between two adjacent first light blocking structures (410) of the plurality of first light blocking structures (410), and a gap between two adjacent second light blocking structures of the plurality of second light blocking structures (410) is 1 µm or more, and
each of the gap between the two adjacent first light blocking structures (410) and the gap between the two adjacent second light blocking structures (410) are at least 4 times the width of each of the plurality of first light blocking structures (410) and the plurality of second light blocking structures (410).
